# EUROPEAN PATENT APPLICATION

(11) **EP 4 389 942 A1**
(43) Date of publication of application: **26.06.2024**
(21) Application number: 22307006.1
(22) Date of filing: 22.12.2022
(51) Int. Cl.: C25D 11/02, C25D 11/16, C25D 11/18, C25D 11/04

(54) **A METHOD OF MANUFACTURING AN INTEGRATED DEVICE COMPRISING ANODIC POROUS OXIDE WITH LIMITED ROUGHNESS**

(71) Applicant: Murata Manufacturing Co., Ltd., Nagaokakyo-shi, Kyoto 617-8555 (JP); Commissariat à l'énergie atomique et aux énergies alternatives, 75015 Paris (FR)
(72) Inventor: SOULIER, Brigitte, 38000 GRENOBLE (FR); ARCHAMBAULT, Sophie, 38054 Grenoble cedex 09 (FR); VOIRON, Frédéric, 38530 BARRAUX (FR); BAUDIN, Floriane, 38054 Grenoble cedex 09 (FR); DOMINGUEZ, Sébastien, 38054 Grenoble cedex 09 (FR)
(74) Representative: Cabinet Beau de Loménie

(57) **Abstract**

A method of manufacturing an integrated device comprising an anodic porous
oxide region comprising:
forming, on a substrate, a metal anodization barrier layer,
planarizing the metal anodization barrier layer,
forming, on the planarized metal anodization barrier layer (201P), an anodizable metal layer,
planarizing the anodizable metal layer,
anodizing the planarized anodizable metal layer to obtain the anodic porous oxide region (203) comprising a plurality of substantially straight pores that extend from a top surface of the anodic porous oxide region towards the metal anodization barrier layer.

## Description

### Field of the Invention

The present invention relates to the field of integration and, more particularly, to electrical devices including anodic porous oxides and their methods of manufactures.

### Technical Background

Silicon passive integration technologies are nowadays accessible for industrial design. For example, the PICS technology developed by Murata Integrated Passive Solutions allows integrating high density capacitive components into a silicon substrate. According to this technology, tens or even hundreds of passive components can be efficiently integrated into a silicon die.

In their work entitled "Nanotubular metal-insulator-metal capacitor arrays for energy storage" (published in Natural technology, May 2009), P. Banerjee *et al.* describe a metal-insulator-metal (MIM) structure formed in a porous anodic material, such as porous anodic alumina (PAA) for example. The successive layers of metal, insulator, and then metal follow the contours of the porous material resulting in the MIM structure being embedded inside the pores of the porous material. Banerjee's PAA embedded structure however suffers from high Equivalent Series Resistance (ESR) and limited capacitance density due to the PAA thickness that can be deposited by Atomic Layer Deposition (ALD).

A structure by F. Voiron et al. that improves Banerjee's ESR and capacitance is described in international application publication WO 2015/063420 A1. Voiron's structure results in highly integrated capacitance that may be used in a variety of applications. In this structure the bottoms of the pores are opened and the lower metal layer of the MIM structure contacts a conductive layer that underlies the porous region, providing electrical contact and reducing ESR.

Generally, PAA embedded structures as described above result from embedding a structure (e.g., a MIM capacitive stack) inside a porous region above a substrate, such as a silicon wafer. Typically, the porous region results from anodizing a thin layer of metal, such as aluminum, deposited above the substrate. The anodization converts the aluminum layer into porous anodic alumina. Typically, the porous region is formed with any shape (as viewed from the top) and extends across the alumina layer in a direction perpendicular to the wafer surface.

In the solutions of the prior art, the aluminum layer (or a layer containing another anodizable metal) is usually formed above layer of metal that forms an anodization barrier (for example containing tungsten). The metal barrier is used to prevent anodization of the underlying substrate (if it contains anodizable material), the anodization process creates an oxide of the material of the barrier layer at the bottom ends of the pores, which may subsequently prevent the anodization fluid and the pores from progressing into the underlying substrate.

Also, should the substrate be insulating, the metal barrier layer can distribute the anodization potential (it may also be referred to as the electrode collector).

It has been observed that not all the pores in an anodization process reach the metal barrier layer at the same time. Consequently, and if the anodization process is stopped too early, portions of aluminum may remain between the anodic porous oxide and the metal barrier layer.

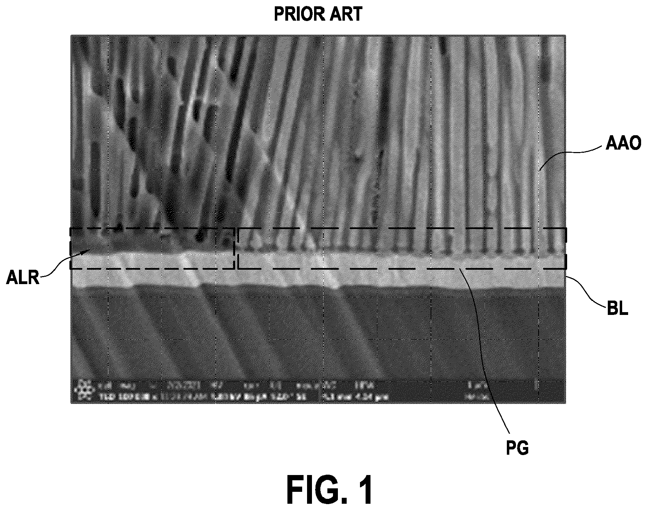

Figure 1 is a TEM image of an interface between a metal barrier layer BL and an anodic porous oxide region AAO, with vertical pores on the figure that reach the metal barrier layer in zone PG, where the pores are plugged up at their bottom ends by an oxide of the material of the metal barrier layer. A group of pores visible on the figure do not reach the metal barrier layer, and there remains a residue of aluminum ALR.

The residue of aluminum might react in subsequent process steps (typically if titanium nitride (TiN) is deposited inside the pores using titanium tetrachloride as precursor). The residue also prevents obtaining a desired electrical contact between at the bottom of the pores and may therefore add resistance.

Avoiding the aluminum residues can by partially achieved by extending the anodization time. This solution however risks forming wide oxide plugs at the bottom of the pores. As the oxide plugs are usually removed in an etching step, removing these wide plugs has been observed to result in the anodic porous oxide delaminating completely.

The above issue (the presence of aluminum residues) is problematic in processes in which the metal barrier layer is continuous (for example over an entire wafer), and it is also an issue for patterned metal barrier layers.

As there exists a need for components including multiple capacitors each having specific properties, metal barrier layers can be patterned.

Document WO 2015/063420 A1 discloses a solution for producing a plurality of different capacitors (at least in terms of capacitance) on a same substrate. In this document, the bottom electrodes the capacitors can be formed above a patterned metal barrier layer, with insulation between the portions of metal barrier.

Document EP 3680931 proposes using a patterned metal barrier layer and an underlying insulating layer to obtain a lateral isolation surrounding capacitors.

When the metal barrier layer is patterned and not formed on a conductive substrate, islands of metal barrier are not electrically connected to the anodization potential. It has been observed that in this configuration, the interface between the metal barrier and the anodic porous oxide is speckled with aluminum residue.

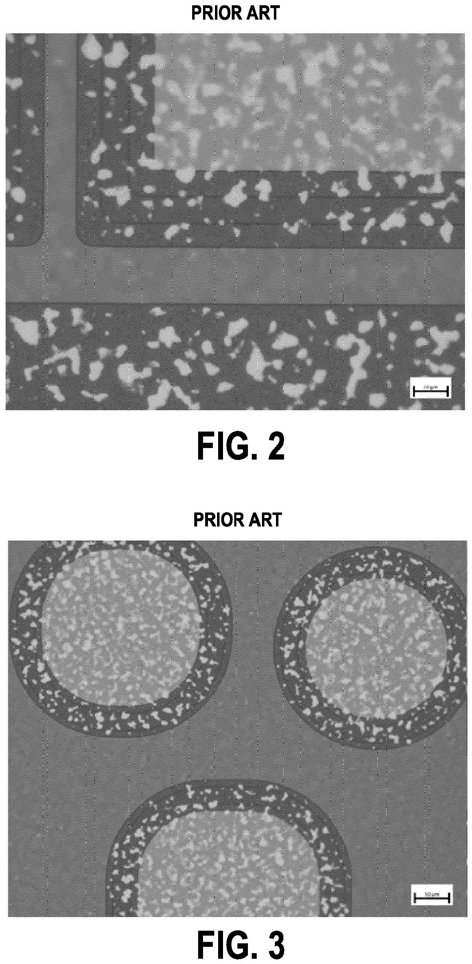

The microscope images of figures 2 and figure 3 show how in zones in which the metal barrier layer is not connected to the anodic potential (for example in the circular regions of figure 3), a significant amount of aluminum remains all over the surface.

The presence of aluminum in this configuration is also detrimental in terms of resistance and reaction during subsequent process steps.

The present invention has been made in the light of the above problems.

### Summary of the Invention

The present invention provides a method of forming an anodic porous oxide region comprising:
forming, on a substrate, a metal anodization barrier layer,
planarizing the metal anodization barrier layer,
forming, on the planarized metal anodization barrier layer, an anodizable metal layer,
planarizing the anodizable metal layer,
anodizing the planarized anodizable metal layer to obtain the anodic porous oxide region comprising a plurality of substantially straight pores that extend from a top surface of the anodic porous oxide region towards the metal anodization barrier layer.

The anodization step can be performed for the entire metal layer or for one or several distinct portions of it (typically using an anodizing mask).

The inventors of the present invention have observed that the unanodized metal residues that can be present at the interface between an anodic porous oxide region and an underlying metal anodization barrier layer result from the roughness of the aluminium prior to anodizing.

In fact, the roughness introduces thickness differences and, in the thicker portions, the pores cannot reach the metal anodization barrier layer before the end of the anodization process.

The roughness results from the polycrystalline nature of the anodizable metal layer and of the metal anodization barrier layer.

Thus, by planarizing the metal anodization barrier layer and the anodizable metal layer, all the pores progress in the anodizable metal to the same depth at the same time, and reach the metal anodization barrier layer at the same time.

This allows preventing pores from not reaching the barrier and avoids metal residues.

According to a particular embodiment, the method comprises patterning the metal anodization barrier layer to obtain at least two separate metal anodization barrier portions and forming an insulating region separating the at least two metal anodization barrier portions,
wherein planarizing the metal anodization barrier layer comprises planarizing the at least two metal anodization barrier portions and the insulating region.

After the planarizing of the metal anodization barrier, a flat surface is obtained as the insulating region is flush with the top surface of the metal anodization barrier layer.

According to a particular embodiment, the method comprises depositing a layer of insulating material between the at least two metal anodization barrier portions and over the at least two metal anodization barrier portions, and wherein planarizing the metal anodization barrier layer comprises removing the insulating material deposited above the at least two metal anodization barrier portions (at this stage, no insulating material remains above the at least two metal anodization barrier portions).

Thus, it is not necessary to delimit the insulating material, the insulating material remaining over the metal anodization barrier layer is removed during the planarizing step.

According to a particular embodiment, planarizing the metal anodization barrier layer and/or planarizing the anodizable metal layer comprises reaching a an average surface roughness comprised between 1nm and 10nm and/or a maximal peak to valley height of less than 30nm.

The average surface roughness can be expressed using an average roughness parameter such as Ra, Rq (respectively the arithmetic average and the quadratic average). The maximal peak to valley height can be expressed using the parameter Rmax.

It should be noted that these surface roughness parameters cannot be achieved when PVD (including sputtering) or evaporation methods are used to deposit metals to form an anodization barrier or anodizable metals.

An average surface roughness comprised between 1nm and 10nm and a maximal peak to valley height of less than 30nm is achieved by means of the planarizing and has been observed to allow all the pores to progress at the same level.

By way of example, if a CMP is used, this CMP can include a final step to tune the surface roughness. For example, this step can comprise a buffing, or an Ar sputtering, or both.

According to a particular embodiment, anodizing the anodizable metal layer comprises performing an anodization of the entire anodizable metal layer.

For example, in this embodiment, the anodization is performed without an anodization mask. An anodizable metal layer formed all over a wafer can be anodized in this embodiment.

According to a particular embodiment, the method comprises, prior to the anodization, forming an anodization mask having an opening, to obtain (after anodizing) the porous region under the opening surrounded by unanodized metal covered by the anodization mask.

The anodization mask can be referred to as a hard mask. Delimiting the area to be anodized can be performed by means of a hard mask/an anodization mask using the method disclosed in application WO 2019/202046.

According to a particular embodiment, planarizing the anodizable metal layer is performed through the opening of the anodization mask by electropolishing.

In this embodiment, only the portion of the anodizable metal layer accessible through the opening is planarized.

According to a particular embodiment, the method comprises, depositing an initial anodizable metal layer, forming, prior to the anodization, an anodization mask having an opening that opens onto the initial anodizable metal layer, depositing a filling portion of the anodizable metal material to obtain the anodizable metal layer, and wherein planarizing the anodizable metal layer is performed by chemical mechanical polishing (CMP).

In this embodiment, the anodizable metal layer is formed in two steps, first an initial layer is deposited, and second a filling portion is formed in the opening. This allows using a CMP process to planarize the anodizable metal layer with the anodization mask present. Also, in this embodiment, the anodization mask may also be planarized, simultaneously with the anodizable metal layer and this mask is flush with the top surface of the anodizable metal layer. Here, the anodizable metal layer has a salient portion within the opening. When the anodizing is performed, there remains an anodization mask with an opening around the planarized anodizable metal layer.

According to a particular embodiment, forming the anodizable metal layer comprises forming a recess in a preliminary anodizable metal layer (for example through a photolithography step) to obtain the anodizable metal layer, filling the recess with an anodization mask, and wherein planarizing the anodizable metal layer is performed by chemical mechanical polishing (CMP).

The structure obtained in this step is analogous to the one obtained in the previously described embodiment wherein a filling portion is used.

In this embodiment, the anodizable metal layer is formed in two steps, first a preliminary layer is deposited, then it is patterned to form a recess (for example having a depth comprised between 500nm and 1µm). The hard anodization mask can have an initial thickness comprised between 600 and 1.1µm. Also, in this embodiment, the anodization mask may also be planarized, simultaneously with the anodizable metal layer and this mask is flush with the top surface of the anodizable metal layer. Here, the anodizable metal layer has a salient portion within the opening. When the anodizing is performed, there remains an anodization mask with an opening around the planarized anodizable metal layer.

According to a particular embodiment, the method comprises forming a stacked capacitive structure inside a group of pores of the anodic porous oxide region, the stacked capacitive structure comprising a bottom electrode layer in contact with the metal anodization barrier layer, a top electrode layer, and a dielectric layer arranged between the bottom and the top electrode layer.

The above structure is particularly adapted to receive a stacked capacitive structure inside the pores, with the electrode layers and the dielectric layer being deposited in a conformal manner, for example using atomic layer deposition (ALD) techniques.

According to a particular embodiment, the substrate comprises an insulating region on its top surface below and in contact with the metal anodization barrier layer.

The invention is particularly adapted when the substrate is insulating, such that separate portions of metal anodization barrier are not at the anodization potential.

The invention also provides an integrated device comprising a anodic porous oxide region comprising:
a substrate,
a metal anodization barrier layer on the substrate having a planarized top surface,
the anodic porous oxide region being arranged on the metal anodization barrier and comprising a plurality of substantially straight pores that extend from a top surface of the porous region towards the metal anodization barrier layer, the anodic porous oxide region having a top surface having an average surface roughness of less than 20nm.

This structure can be manufactured using any one of the embodiments of the above defined method.

According to a particular embodiment, the metal anodization barrier layer has an average surface roughness comprised between 1nm and 10nm and/or a maximal peak to valley height of less than 30nm.

This roughness corresponds to a planarizing step having been performed. Also, it may be observed in a SEM cross section and even optically through the AAO.

According to a particular embodiment, the anodic porous oxide region is surrounded by unanodized metal having an average roughness parameter comprised between 20nm and 50nm.

This particular embodiment concerns a partial anodizing of the metal, for example when an anodization mask is used, and when no planarization has been performed on the metal covered by the anodization mask.

According to a particular embodiment, the metal anodization barrier layer is patterned into at least two separate metal anodization barrier portions, the structure further comprising an insulating region separating the at least two metal anodization barrier portions,
wherein the insulating region is flush with the at least two metal anodization barrier portions.

According to a particular embodiment, the structure comprises an anodization mask having an opening delimiting the porous region.

According to a particular embodiment, the anodic porous oxide region is flush with the top surface of the anodization mask.

According to a particular embodiment, the structure comprises a stacked capacitive structure inside a group of pores of the anodic porous oxide region, the stacked capacitive structure comprising a bottom electrode layer in contact with the metal anodization barrier layer, a top electrode layer, and a dielectric layer arranged between the bottom and the top electrode layer.

According to a particular embodiment, the substrate comprises an insulating region on its top surface below and in contact with the metal anodization barrier layer.

### Brief Description of the Drawings

Further features and advantages of the present invention will become apparent from the following description of certain embodiments thereof, given by way of illustration only, not limitation, with reference to the accompanying drawings in which:
- Figure 1, 2, and 3, already described, show aluminum residues under anodic porous oxide regions,
- Figure 4 is a schematic illustration of a structure in accordance with the prior art,
- Figure 5 is an AFM image of the surface of a deposited aluminum structure,
- Figure 6 is a schematic illustration of the structure of figure 4 after anodization,
- Figures 7A, 7B, 7C, 7D, and 7E illustrate the steps of a method according to an example,
- Figures 8A, 8B, 8C, 8D, 8E and 8F illustrate the steps of a method according to another example,
- Figures 9A and 9B illustrate using a hard mask according to an example,
- Figure 10 illustrate using a hard mask according to another example,
- Figures 11A and 11B are images of a device according to an example,
- Figures 12A, 12B, 12C, and 12D are obtained using AFM on planarized and non-planarized devices.

### Detailed Description of Example Embodiments

We will now describe a method of manufacturing an integrated device and the corresponding integrated device. In this method, anodizable metal is anodized to obtain substantially straight pores that reach a metal anodization barrier. For example, in the present description, anodic porous oxide regions are regions which initially comprised a metal, for example aluminum, and which have been anodized so as to comprise straight pores extending from a top surface in the entire thickness of the layer, in a direction which is substantially perpendicular to the plane on which the layer is deposited to reach the metal anodization barrier layer.

The anodic porous oxide regions described herein can accommodate a capacitor inside the pores, for example by forming a stacked capacitive structure inside a group of pores of the anodic porous oxide region, the stacked capacitive structure comprising a bottom electrode layer in contact with the metal anodization barrier layer, a top electrode layer, and a dielectric layer arranged between the bottom and the top electrode layer.

Other components may also be formed inside the pores described in the present description (for example resistors, inductors, etc.).

In the present description, aluminum is used as anodizable metal and tungsten is used as metal anodization barrier. Other metals can be used.

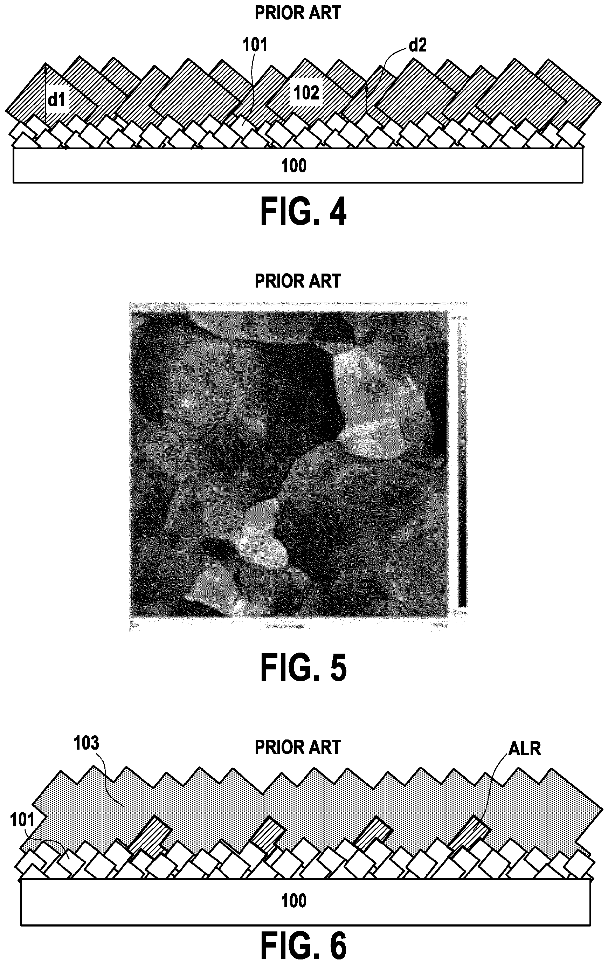

Figure 4 shows a starting structure, prior to anodization, in accordance with the methods of the prior art. On this figure, a substrate 100 is covered by a metal barrier layer 101 which is itself covered by a layer of anodizable metal 102. Here, the metal barrier layer comprises tungsten and the layer of anodizable metal comprises aluminum.

Depositing the metal barrier layer 101 and the can be performed using a Physical Vapor Deposition (PVD) technique or an evaporation technique or a CVD technique (although it should be noted that PVD and evaporation are preferred for thermal budget management reasons). These two techniques result in a polycrystalline layer of metal. Consequently and as shown on figure 4, the surface of this layer can have a roughness.

Depositing the anodizable metal layer 102 comprising aluminum may also be performed using a Physical Vapor Deposition (PVD) technique or an evaporation technique. Consequently and also because of the rough interface between layers 101 and 102, the aluminum layer, prior to anodization, has a rough surface (typically an average roughness comprised between 20nm and 50nm).

This rough surface is illustrated on figure 1 where two thicknesses d1 and d2 are shown between the top surface of the aluminum and the interface between aluminum and the barrier layer, with d1 being superior to d2.

Figure 5 is an AFM image of the surface of an aluminum layer such as the one of figure 4. The multiple grains of the surface are visible.

After an anodization step has been carried out, anodic porous oxide 103 is obtained, and because of the differences of thicknesses, there remains an aluminum residue ALR, as shown on figure 6.

Thus, the inventors of the present invention have observed that the aluminum residues result from the roughness of the aluminum and of the interface between aluminum and the metal barrier.

Also, it has been observed that it is not possible to deposit a monocrystalline aluminum layer over an entire substrate using known deposition techniques.

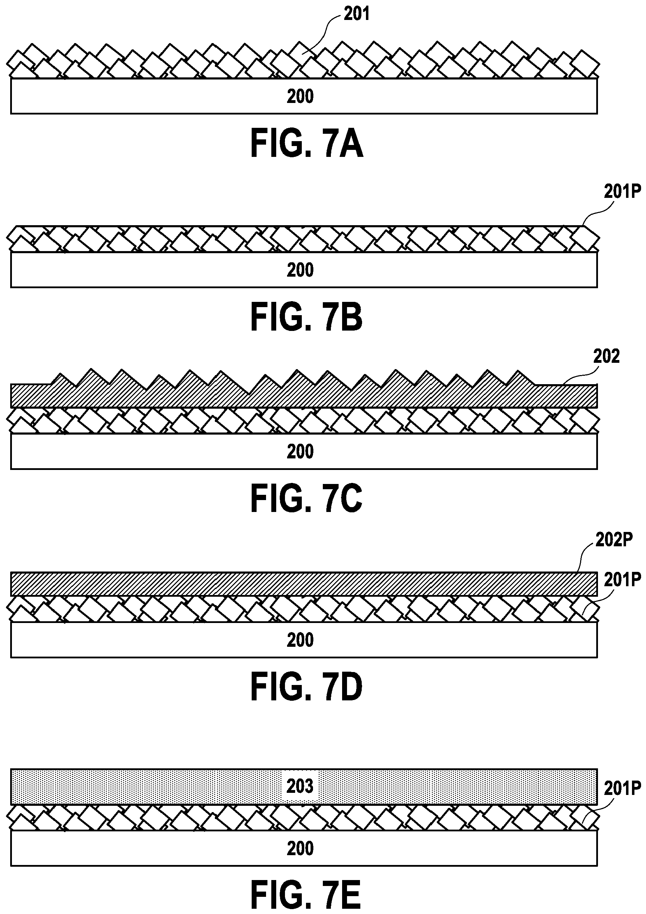

Figure 7A shows a base structure obtained after depositing a layer of tungsten 201 over a substrate (for example an substrate insulating at the level of the interface with the layer of tungsten 201). Layer 201 is polycrystalline and presents a given roughness. For example, it has been formed by for example by PVD or evaporation.

Figure 7B shows how layer 201 is planarized to obtain layer 201P, for example using a CMP process.

On figure 7C, the structure of figure 7B is shown with a layer of aluminum 202 formed, for example by PVD or evaporation on the layer. This layer has a roughness and is polycrystalline.

Figure 7D shows how layer 202 is planarized to obtain layer 202P, for example using a CMP process.

At this stage, the planarized aluminum layer 202P and the planarized tungsten layer 201P have an average surface roughness comprised between 1nm and 10nm and/or a maximal peak to valley height of less than 30nm.

Subsequently and as shown on figure 7E, the aluminum layer 7E can be anodized to obtain an anodic porous oxide region 203 comprising a plurality of substantially straight pores that extend from a top surface of the anodic porous oxide region towards the tungsten layer 201P. The anodization process allows forming an anodic porous oxide region devoid of aluminium residues as all the pores reach the tungsten layer 201P at the same time. An integrated device is obtained using this structure.

In the example of figure 7E, the entire anodizable metal layer is anodized, no anodization mask is used, this configuration having the advantage of avoiding cracks that may appear when a hard mask is used.

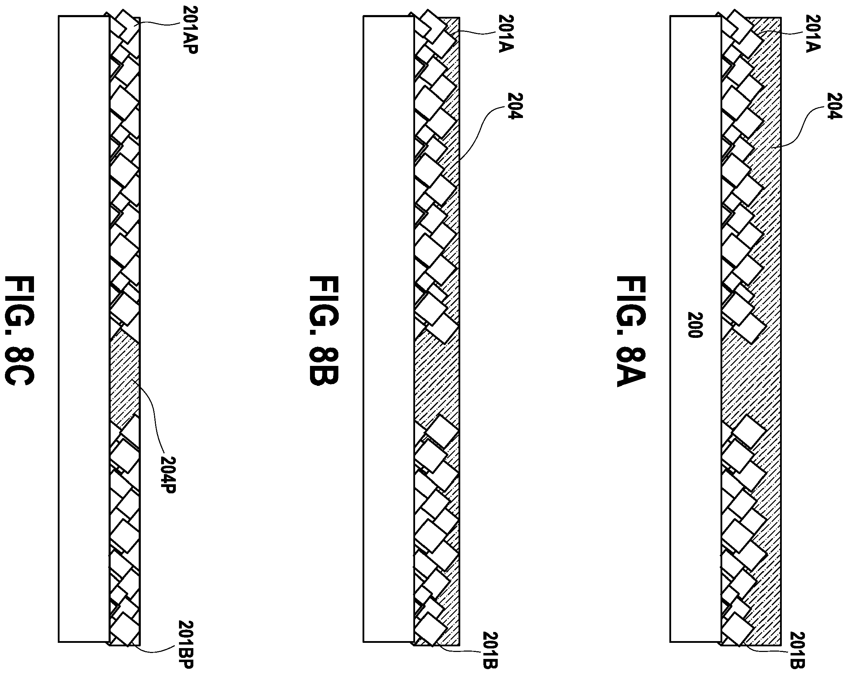

Figures 8A to 8F show another method. In these figures, the references of figures 7A to 7E may also be used to designate the same elements (this also applies to other figures in the present description).

Figure 8A shows a structure comprising two portions 201A and 201B of tungsten: the tungsten anodization barrier has been patterned in a photolithography step to obtain the two separate portions. Above and on the two portions 201A and 201B, an insulating layer 204 has been formed, also in the opening between the two portions. For example, the insulating layer 204 can comprise silicon dioxide formed using a low temperature PECVD (Plasma-enhanced chemical vapor deposition) process. For example, the thickness of the insulating layer can be greater than the thickness of the tungsten portions.

A planarizing of the two portions 201A and 201B and of the insulating layer can now be performed.

Here, the planarizing is performed in two sub-steps. Figure 8B shows the output of a first planarizing sub-step with a process that is selective with respect to tungsten (the etching speed of silicon dioxide is far greater than the etching speed of tungsten). By way of example, this can be carried out by a CMP using a slurry that provides this selectivity.

In a second sub-step, a non-selective CMP can be used to remove any insulating material deposited over the two tungsten portions. At this stage, there remains a planarized insulating region 204P separating the two planarized tungsten portions 201AP and 201BP.

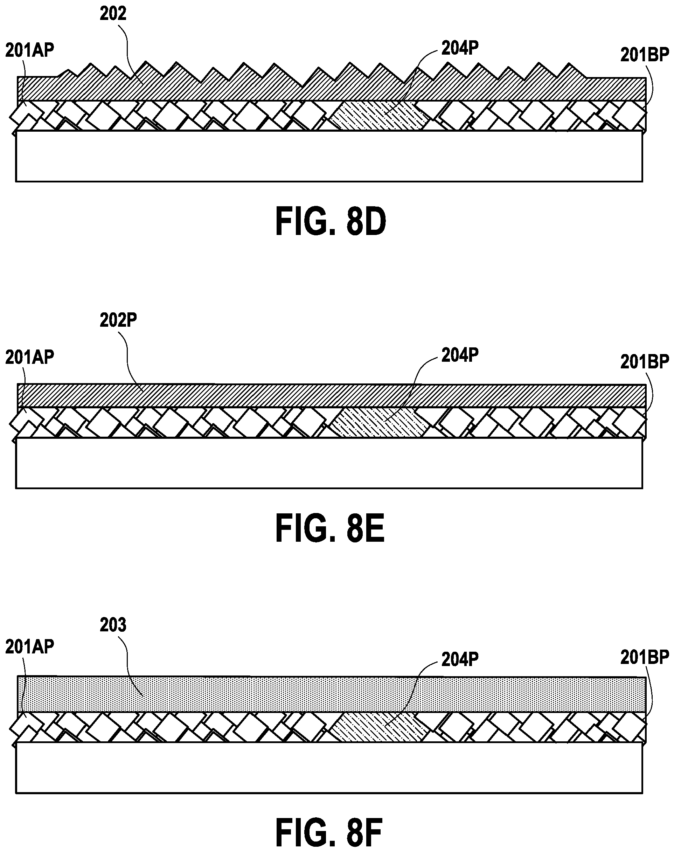

An aluminium layer 202 can then be deposited (figure 8D) and planarized to obtain planarized aluminium layer 202P (figure 8E).

Anodization can then be performed, as shown on figure 8F to obtain anodic porous oxide region 203.

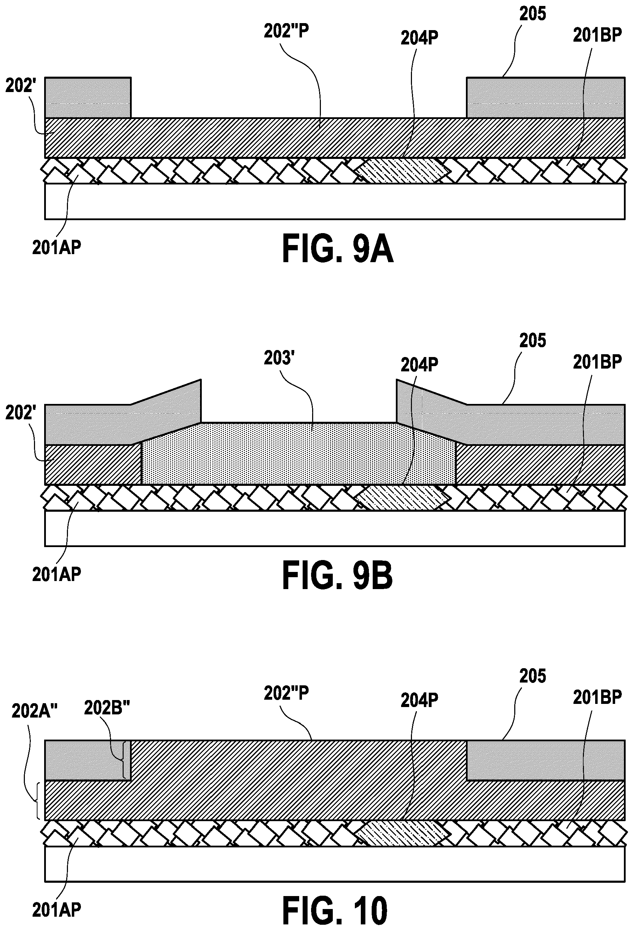

Figure 9A shows how a hard mask 205 can be used to delimit a portion of aluminum to be anodized, using the method disclosed in document WO 2019/202046 and when starting of a structure such as the one of figure 8D described previously.

It is possible to only planarize the aluminum layer through an opening of the hard mask 205 that opens onto un-planarized aluminum by using electropolishing. Thus, planarized aluminum 202'P is obtained at the level of the opening and, under the hard mask, un-planarized aluminum 202' remains.

Figure 9B shows the structure of figure 9A after an anodizing has been performed, to obtain anodized portion 203' surrounded by un-planarized aluminum 202'.

Figure 10 shows an alternative method in which an initial aluminum layer 202A" is formed prior to forming the hard mask 205 with an opening, and wherein a filling portion 202B" of aluminum is deposited to fill this opening. This allows performing a planarizing by CMP of both the hard mask and the filling portion 202B", to obtain planarized aluminum layer 202"P. The surface of the planarized aluminum layer 202"P is flush with the top surface of the hard mask 205.

It is also possible to obtain a similar structure by forming a recess in a preliminary aluminum layer (for example through a photolithography step) to obtain the aluminum layer to be planarized, filling the recess with an anodization mask, and wherein planarizing the anodizable metal layer is performed by chemical mechanical polishing (CMP).

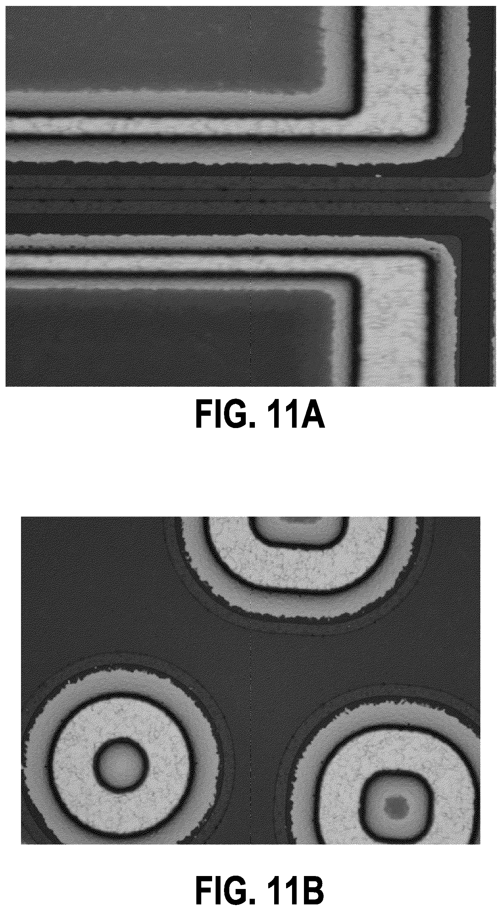

Figures 11A and 11B respectively correspond to the structures of figures 2 and 3 and show structure made in accordance with the above-described processes. No aluminum residue can be observed.

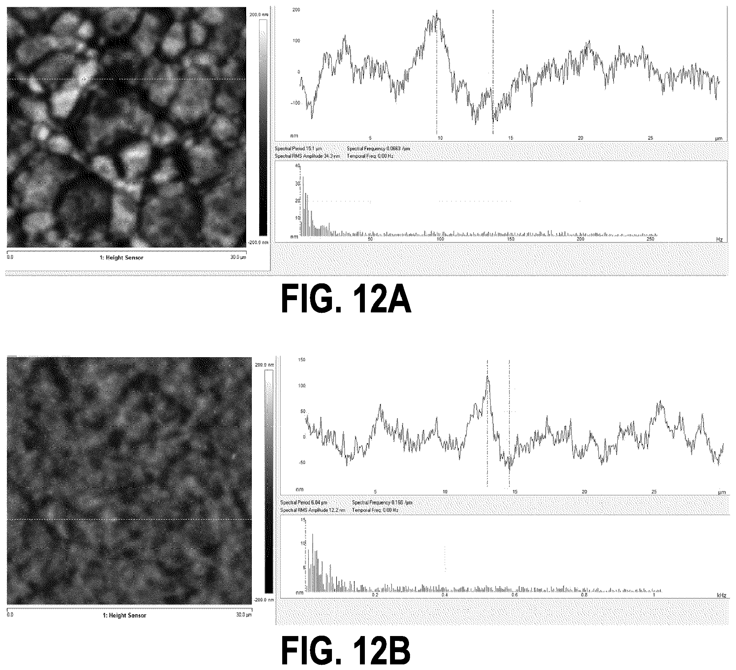

Figure 12A is an AFM image of a top surface of anodic porous oxide obtained using the methods of the prior art, i.e. without planarization. It can be observed that roughness shows a Rmax value of about 350nm, and RMS amplitude of 35nm, and a typical spatial period of about 15µm which corresponds to the grains of aluminum prior to anodization.

In fact, the grains are reproduced in the anodic porous oxide.

Figure 12B is an AFM image of a top surface of anodic porous oxide using the methods such as the ones described in reference to figures 7A to 10. Here, The Rmax value is about 100nm, the typical period is about 6µm, the RMS amplitude of about 12nm. Thus, the two planarization steps provide much lower amplitude and a much higher frequency compared to the anodic porous oxide observed on figure 12A.

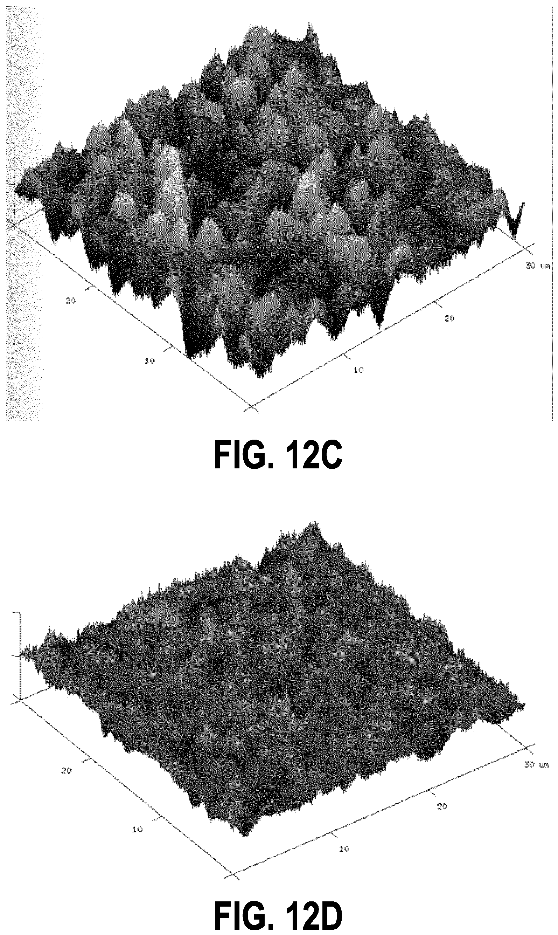

Figure 12C and 12D are three-dimensional representations respectively corresponding to the images of figures 12A and 12B.

## Claims

1. A method of manufacturing an integrated device comprising an anodic porous
oxide region comprising:
forming, on a substrate (200), a metal anodization barrier layer (201),
planarizing the metal anodization barrier layer,
forming, on the planarized metal anodization barrier layer (201P), an anodizable metal layer (202),
planarizing the anodizable metal layer,
anodizing the planarized anodizable metal layer (202P) to obtain the anodic porous oxide region (203) comprising a plurality of substantially straight pores that extend from a top surface of the anodic porous oxide region towards the metal anodization barrier layer.

2. The method of claim 1, comprising patterning the metal anodization barrier layer to obtain at least two separate metal anodization barrier portions (201A, 201B) and forming an insulating region separating the at least two metal anodization barrier portions,
wherein planarizing the metal anodization barrier layer comprises planarizing the at least two metal anodization barrier portions (201AP, 201BP) and the insulating region (204P).

3. The method of claim 2, comprising depositing a layer (204) of insulating material between the at least two metal anodization barrier portions and over the at least two metal anodization barrier portions, and wherein planarizing the metal anodization barrier layer comprises removing the insulating material deposited above the at least two metal anodization barrier portions.

4. The method of any one of claims 1 to 3, wherein planarizing the metal anodization barrier layer and/or planarizing the anodizable metal layer comprises reaching a surface roughness of less than an average surface roughness comprised between 1nm and 10nm and/or a maximal peak to valley height of less than 30nm.

5. The method of any one of claims 1 to 4, wherein anodizing the anodizable metal layer comprises performing an anodization of the entire anodizable metal layer.

6. The method of any one of claims 1 to 4, comprising, prior to the anodization, forming an anodization mask having an opening, to obtain the porous region under the opening surrounded by unanodized metal covered by the anodization mask.

7. The method of claim 6, wherein planarizing the anodizable metal layer is performed through the opening of the anodization mask by electropolishing.

8. The method of claim 6, comprising depositing an initial anodizable metal layer, forming, prior to the anodization, an anodization mask having an opening that opens onto the initial anodizable metal layer, depositing a filling portion of the anodizable metal material to obtain the anodizable metal layer, and wherein planarizing the anodizable metal layer is performed by chemical mechanical polishing.

9. The method of claim 6, wherein forming the anodizable metal layer comprises forming a recess in a preliminary anodizable metal layer to obtain the anodizable metal layer, filling the recess with an anodization mask, and wherein planarizing the anodizable metal layer is performed by chemical mechanical polishing.

10. The method of any one of claims 1 to 9, comprising forming a stacked capacitive structure inside a group of pores of the anodic porous oxide region, the stacked capacitive structure comprising a bottom electrode layer in contact with the metal anodization barrier layer, a top electrode layer, and a dielectric layer arranged between the bottom and the top electrode layer.

11. The method of any one of claims 1 to 10, wherein the substrate comprises an insulating region on its top surface below and in contact with the metal anodization barrier layer.

12. An integrated device comprising a anodic porous oxide region comprising:
a substrate (200),
a metal anodization barrier layer (201P) on the substrate having a planarized top surface,
the anodic porous oxide region (203) being arranged on the metal anodization barrier and comprising a plurality of substantially straight pores that extend from a top surface of the porous region towards the metal anodization barrier layer, the anodic porous oxide region having a top surface having an average surface roughness of less than 20nm.

13. The integrated device of claim 12, wherein the metal anodization barrier layer has an average surface roughness comprised between 1nm and 10nm and/or a maximal peak to valley height of less than 30nm.

14. The integrated device of claim 12 or 13, wherein the anodic porous oxide region is surrounded by unanodized metal (202') having an average roughness parameter comprised between 20nm and 50nm.

15. The integrated device of any one of claims 12 to 14, wherein the metal anodization barrier layer is patterned into at least two separate metal anodization barrier portions (201AP, 201BP), the structure further comprising an insulating region (204P) separating the at least two metal anodization barrier portions,
wherein the insulating region is flush with the at least two metal anodization barrier portions.

16. The integrated device of any one of claims 12 to 15, comprising an anodization mask having an opening delimiting the porous region.

17. The integrated device of claim 16, wherein the anodic porous oxide region is flush with the top surface of the anodization mask.

18. The integrated device of any one of claims 12 to 17, comprising a stacked capacitive structure inside a group of pores of the anodic porous oxide region, the stacked capacitive structure comprising a bottom electrode layer in contact with the metal anodization barrier layer, a top electrode layer, and a dielectric layer arranged between the bottom and the top electrode layer.

19. The integrated device of any one of claims 12 to 18, wherein the substrate comprises an insulating region on its top surface below and in contact with the metal anodization barrier layer.
